# EUROPEAN PATENT APPLICATION

(11) **EP 2 562 769 A1**
(43) Date of publication of application: **27.02.2013**
(21) Application number: 11772063.1
(22) Date of filing: 21.04.2011
(51) Int. Cl.: H01B 12/06, C01G 1/00, C01G 3/00, H01B 13/00, H01F 6/06

(54) **OXIDE SUPERCONDUCTOR AND PRODUCTION METHOD FOR SAME**

(30) Priority: 21.04.2010 JP 2010097808
(71) Applicant: Fujikura, Ltd., Tokyo 135-8512 (JP)
(72) Inventor: IGARASHI Mitsunori, Sakura-shi, Chiba 285-8550 (JP)
(74) Representative: Hodsdon, Stephen James
(86) International application number: PCT/JP2011/059812
(87) International publication number: WO 2011/132731

(57) **Abstract**

An oxide superconducting conductor of the invention is configured to include a substrate; and an oxide superconducting layer formed on the substrate. The oxide superconducting layer is an oxide superconductor being expressed by a composition formula of RE₁Ba₂Cu₃O_{y} where RE represents a rare earth element and an expression of 6.5 < y < 7.1 is satisfied. The oxide superconducting layer has a different phase including Tb. The different phase is dispersed in the oxide superconducting layer.

## Description

### TECHNICAL FEILD

The invention relates to an oxide superconducting conductor and a method of manufacturing the same.
Priority is claimed on Japanese Patent Application No. 2010-097808, filed April 21, 2010, the content of which is incorporated herein by reference.

### BACKGROUND ART

An RE123-based oxide superconducting conductor is expressed by a composition of RE₁Ba₂Cu₃O_{y} (RE: a rare earth element, such as Y or Gd, 6.5 < y < 7.1), has a critical temperature that is higher than the temperature of liquid nitrogen (77 K), and is expected to be applied to superconducting equipment, such as superconducting devices, transformers, fault current limiters, motors, and magnets.
Generally, a superconductor that is formed using an RE123-based oxide superconductor so as to have favorable crystalline orientation exhibits high critical current characteristics in the absence of a magnetic field.
However, when a magnetic field is applied to a superconductor in a superconducting state and an electric current is applied, a Lorentz force is generated in a quantized magnetic flux that has intruded into the superconductor.
At this time, when the quantized magnetic flux is moved by the Lorentz force, a voltage is generated in the direction of the electric current, and a resistance is caused.
Since the Lorentz force increases as the electric current value increases, and the magnetic field becomes stronger, the resistance increases, and the critical current characteristics degrade.

As a solution for the above problem, it is generally known that nanoscale different phases, such as impurities or defects, are doped into a superconducting layer, and the magnetic flux is pinned, thereby improving the critical current characteristics of the superconductor in a magnetic field.
As such a method, for example, a method in which the amount of a superconducting material substituted with Re and Ba, the substrate temperature during formation of a superconducting layer, or the oxygen partial pressure is controlled so as to control the amount of stacking faults caused in the superconducting layer, thereby introducing fine pinning points in a superconducting laminate (refer to Patent Document 1) is proposed.
Alternately, a method in which columnar crystals of a Ba oxide having the perovskite structure, such as BaZrO₃, BaWO₄, BaNb₂O₆, BaSnO₃, BaHfO₃, or BaTiO₃, are introduced and arranged intermittently in the film thickness direction of a superconducting layer in the superconducting layer composed of an RE123-based oxide superconductor is proposed (refer to Patent Document 2).

### PRIOR ART DOCUMENTS

### PATENT DOCUMENTS

[Patent Document 1] Japanese Unexamined Patent Application, First Publication No. 2005-116408
[Patent Document 2] Japanese Unexamined Patent Application, First Publication No. 2008-130291

### DISCLOSURE OF INVENTION

### PROBLEMS TO BE SOLVED BY THE INVENTION

However, an attempt to improve the critical current characteristics in a magnetic field by introducing stacking defects as described in Patent Document 1 becomes a principle in which the optimal conditions for formation of a superconducting thin film, which makes a high critical current possible, are intentionally avoided.
Originally, it is necessary to strictly control the conditions for film formation when a superconducting layer is formed.
Therefore, the method in which a superconducting layer is formed by changing the conditions of film formation, such as the oxygen partial pressure and the substrate temperature, as described in Patent Document 1 becomes a film-forming method outside the optimal conditions for film formation.
As a result, there are problems in that the critical current characteristics are significantly deteriorated, it becomes difficult to control the amount of defects, and it becomes difficult to manufacture a superconducting wire having uniform critical current characteristics throughout the longitudinal direction thereof.
In addition, in an attempt to improve the critical current characteristics in a magnetic field by introducing columnar crystals into a superconducting layer as described in Patent Document 2, it is easy to control the stacking defects, but there is a problem in that the critical current characteristics are degraded in the absence of a magnetic field or in an extremely low magnetic field area.
In addition, since the columnar crystals grow excessively in parallel with the c axis (the film thickness direction of the superconducting layer; the vertical manner to a substrate of the superconducting wire), a strong effect of suppressing the movement of the quantized magnetic flux can be obtained in a case in which a magnetic field is applied in the c-axis direction; however, in a case in which a magnetic field is applied at other angles, such as in the 45° direction with respect to the c axis, the effect of suppressing the movement of the quantized magnetic flux is weak, and thus there is a problem in that the critical current characteristics become somewhat significantly degraded.

The invention has been made in consideration of the above circumstances, and an object of the invention is to provide an oxide superconducting conductor which suppresses degradation of the critical current in a magnetic field and has favorable critical current characteristics, and a method of manufacturing the same.

### MEANS FOR SOLVING THE PROBLEMS

In order to solve the aforementioned problem, an oxide superconducting conductor of a first aspect of the invention includes: a substrate; and an oxide superconducting layer formed on the substrate.
The oxide superconducting layer is an oxide superconductor expressed by a composition formula of RE₁Ba₂Cu₃O_{y} where RE represents a rare earth element and the expression of 6.5 < y < 7.1 is satisfied.
A different phase including Tb is dispersed in the oxide superconducting layer.
In the oxide superconducting conductor of the first aspect of the invention, it is preferable that the different phase be an oxide including Ba and Tb.
In the oxide superconducting conductor of the first aspect of the invention, it is preferable that the different phase include columnar crystals caused by the Tb which is tetravalent and point defects caused by the Tb which is trivalent.
In the oxide superconducting conductor of the first aspect of the invention, it is preferable that the Tb be included in the oxide superconducting layer in a range of 0.1 mass% to 4 mass% with respect to the RE₁Ba₂Cu₃O_{y} where RE represents a rare earth element and the expression of 6.5 < y < 7.1 is satisfied.
In the oxide superconducting conductor of the first aspect of the invention, it is preferable that an intermediate layer and a cap layer be interposed between the substrate and the oxide superconducting layer in this order, and a stabilizing layer is formed on the oxide superconducting layer.
In order to solve the aforementioned problem, a method of manufacturing an oxide superconducting conductor of a second aspect of the invention includes: using a target including a constituent element of an oxide superconductor and Tb, the oxide superconductor being expressed by a composition formula of RE₁Ba₂Cu₃O_{y} where RE represents a rare earth element and the expression of 6.5 < y < 7.1 is satisfied; and forming an oxide superconducting layer, in which a different phase including Tb is dispersed, on a substrate by physical vapor deposition.
In the method of manufacturing an oxide superconducting conductor of the second aspect of the invention, it is preferable that, as the target, a sintered target be used in which powder of Tb₄O₇ is doped in a range of 0.1 mol% to 5 mol% with respect to powder including the RE₁Ba₂Cu₃O_{y} where RE represents a rare earth element and the expression of 6.5 < y < 7.1 is satisfied.

### Effects of the Invention

In the oxide superconducting conductor of the first aspect of the invention, Tb whose valence is trivalent or tetravalent is introduced into an RE123-based oxide superconducting layer.
For this reason, the different phase including Tb, particularly, the columnar crystals which are caused by the tetravalent Tb and the point defects which are caused by the trivalent Tb are mixed into the oxide superconducting layer.
Because of this, in a case where a magnetic field is applied in the c-axis direction, due to action of the columnar crystals, a pinning effect in which movement of a quantized magnetic flux is inhibited is obtained.
On the other hand, in a case where a magnetic field is applied in a direction other than the c-axis direction, it is possible to inhibit movement of the quantized magnetic flux due to the point defects.
That is, anisotropy toward a magnetic field is minor in the point defects, and it is possible to isotropically inhibit movement of the quantized magnetic flux.
Moreover, since Tb is trivalent or tetravalent, the columnar crystals which are caused by the tetravalent Tb have a tendency to inhibit growth in the c-axis direction as compared with an artificial pin which is columnar crystals having a conventional simple perovskite structure.
As a result, in the columnar crystals of the tetravalent Tb, the crystals in the c-axis direction grow into a favorable length, and isotropical pinning effect which is due to the point defects caused by the trivalent Tb is synergistically affected, the critical current characteristics can be improved in areas at all angles at which a magnetic field is applied.

According to the method of manufacturing an oxide superconducting conductor of the second aspect of the invention, it is possible to easily manufacture an oxide superconducting conductor exhibiting excellent critical current characteristics by using a raw material in which the constituent element of the oxide superconductor expressed by a composition formula of RE₁Ba₂Cu₃O_{y} and Tb are mixed at a desired proportion.
Furthermore, it is possible to manufacture an oxide superconducting conductor in a simple process with a conventional film formation apparatus by using the target including the constituent element of the oxide superconductor expressed by a composition formula of RE₁Ba₂Cu₃O_{y} and Tb by use of physical vapor deposition such as pulse laser deposition (PLD) or the like.

### BRIEF DESCRIPTION OF THE DRAWINGS

FIG. 1 is a schematic perspective view showing an example of an oxide superconducting conductor according to the invention.
FIG. 2 is a schematic perspective view showing an example of a film-forming apparatus that is used in a method of manufacturing an oxide superconducting conductor of the invention.
FIG. 3 is a graph showing the dependency of critical current on magnetic field application angles.

### EMBODIMENTS FOR CARRYING OUT THE INVENTION

Embodiments of an oxide superconducting conductor of the invention and a method of manufacturing the same will be described.
The oxide superconducting conductor of the invention is provided with a substrate and an oxide superconducting layer formed on substrate.
The oxide superconducting layer is an oxide superconductor which is expressed by a composition formula of RE₁Ba₂Cu₃O_{y}. (RE123) where RE represents a rare earth element and the expression of 6.5 < y < 7.1 is satisfied.
Furthermore, a different phase including Tb is distributed in the oxide superconducting layer.

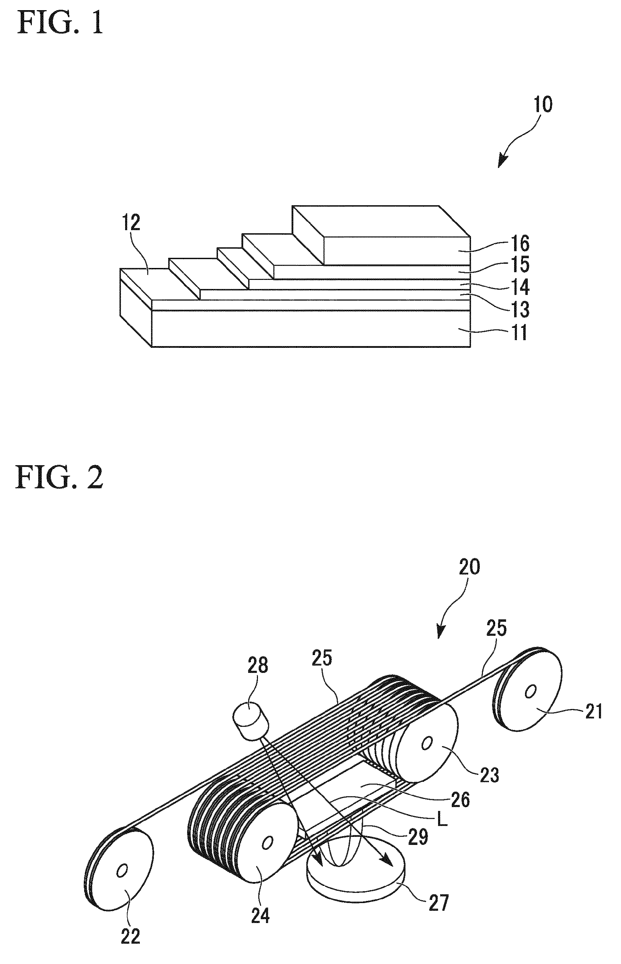

FIG. 1 is a schematic perspective view showing an example of an oxide superconducting conductor according to the invention.
An oxide superconducting conductor 10 as shown in FIG. 1 has a bed layer 12, an intermediate layer 13, a cap layer 14, and an oxide superconducting layer 15 laminated in this order on a substrate 11.
A stabilizing layer 16 is laminated on the oxide superconducting layer 15.
In the oxide superconducting conductor 10, the bed layer 12 may not be provided.

The substrate 11 that can be applied to the oxide superconducting conductor 10 of the embodiment includes substrates that can be used as a substrate for an ordinary superconducting wire or superconducting conductor and have a high strength.
The shape of the substrate 11 is preferably a tape in order to form a long cable.
A material for the substrate 11 is preferably heat-resistant metal.
Examples of the metal includes a variety of metallic materials, for example, silver, platinum, stainless steel, copper, and nickel alloys such as HASTELLOY (trademark of Haynes International, Inc.), materials having ceramics disposed on each of the variety of metallic materials, and the like.
Among the heat-resistant metals, a nickel alloy is preferred.
Among them, as a commercially available product, HASTELLOY is preferred.
As HASTELLOY, any kinds of HASTELLOY B, C, G, N, W, and the like, for which the component amounts of molybdenum, chromium, iron, cobalt, and the like differ, can be used.
The thickness of the substrate 11 may be appropriately adjusted according to purpose, and, ordinarily, is 10 µm to 500 µm.

The bed layer 12 is highly heat-resistant, reduces the interfacial reactivity with the substrate 11, and is used to obtain the orientation of a film that is disposed on the bed layer.
The bed layer 12 is disposed according to necessity, and composed of, for example, yttria (Y₂O**₃**), silicon nitride (Si₃N₄), aluminum oxide (Al₂O₃, also referred to as "alumina"), and the like.
The bed layer 12 is formed by, for example, a film-forming method, such as the sputtering method, and the thickness of the bed layer 12 is, for example, 10 nm to 200 nm.
In addition, in the invention, the structure of the oxide superconducting conductor 10 is not limited to the structure as shown in FIG. 1, and may be a structure in which a diffusion-preventing layer is interposed between the substrate 11 and the bed layer 12.
The diffusion-preventing layer is a layer formed to prevent the constituent elements of the substrate 11 from diffusing into the oxide superconducting layer 15 through the bed layer 12, and composed of silicon nitride (Si₃N₄), aluminum oxide (Al₂O₃), an oxide of a rare earth metal, and the like.
The thickness of the diffusion-preventing layer is, for example, 10 nm to 400 nm.
In addition, since the crystallinity is not required, the diffusion-preventing layer may be formed by a film-forming method, such as an ordinary sputtering method.
When other layers, such as the intermediate layer 13, the cap layer 14, the oxide superconducting layer 15, and the like, which will be described below, are formed on the substrate 11, if the layers are given a thermal history as a result of essential heating or an essential thermal treatment, there are cases in which part of the constituent elements of the substrate 11 diffuse into the oxide superconducting layer 15 through the bed layer 12.
Therefore, when the diffusion-preventing layer is interposed between the substrate 11 and the bed layer 12, diffusion of the constituent elements can be suppressed.
Particularly, diffusion of the elements toward the top of the substrate 11 from the substrate 11 can be effectively suppressed by employing a bilateral structure in which the diffusion-preventing layer and the bed layer 12 are laminated.
As example cases where the diffusion-preventing layer is interposed between the substrate 11 and the bed layer 12, combination can be illustrated by an example in which Al₂O₃ is used as the diffusion-preventing layer and Y₂O₃ is used as the bed layer 12.

The structure of the intermediate layer 13 may be a single layer structure or a multilayer structure.
A material for the intermediate layer 12 is selected from among biaxially-oriented materials in order to control the crystalline orientation of the oxide superconducting layer 15 laminated on the intermediate layer.
Specific examples of the preferable material for the intermediate layer 13 include metallic oxides, such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, and Nd₂O₃.

The thickness of the intermediate layer 13 may be appropriately adjusted according to purpose, and is, ordinarily, in a range of 0.005 µm to 2 µm.
The intermediate layer 13 can be laminated by a well-known method for forming an oxide thin film, such as physical vapor deposition, such as the sputtering method, vacuum deposition, laser deposition, electron beam deposition, or ion beam assist deposition (hereinafter abbreviated as IBAD), chemical vapor deposition (CVD); dipping-pyrolysis processing (MOD); or thermal spraying.
Particularly, the metallic oxide layer formed by IBAD is preferred since the crystalline orientation is favorable, and an effect of controlling the crystalline orientation of the oxide superconducting layer 15 or the cap layer 14 is favorable.
IBAD refers to a method which irradiates a deposition substrate surface with ion beams at a predetermined angle during deposition of a metallic oxide so as to orient crystal axes.
Generally, an argon (Ar) ion beam is used as the ion beam.
For example, the intermediate layer 13 composed of Gd₂Zr₂O₇, MgO, or ZrO₂-Y₂O₃ (YSZ) is particularly preferred since the value of ΔΦ (FWHM: full width at half maximum), which is an index that indicates the degree of crystalline orientation in IBAD, can be decreased.

The cap layer 14 is preferably a layer formed by undergoing a process in which grains epitaxially grow with respect to the surface of the intermediate layer 13, and then grow in the horizontal direction (a direction in parallel with the surface) (overgrowth), whereby the crystal grains selectively grow in the in-plane direction.
The cap layer 14 can produce a higher degree of in-plane orientation than the intermediate layer 13 composed of the metallic oxide layer.
A material for the cap layer 14 is not particularly limited as long as the above function can be developed, but specific examples of the preferable material include CeO₂, Y₂O₃, Al₂O₃, Gd₂O₃, Zr₂O₃, Ho₂O₃, Nd₂O₃, and the like.
In a case in which the material for the cap layer 14 is CeO₂, the cap layer 14 may include a Ce-M-O-based oxide in which part of Ce atoms are substituted with other metal atoms or metal ions.

The CeO₂ layer can be formed by pulse laser deposition (PLD), the sputtering method, or the like, but it is desirable to use PLD since a high film-forming rate can be obtained.
The conditions for forming the CeO₂ layer by PLD include conditions in which the temperature of a substrate is set to approximately 500°C to 1000°C, the pressure is set to approximately 0.6 Pa to 100 Pa, and oxygen is used as a film-forming gas (gaseous atmosphere).
The thickness of the CeO₂ layer is 50 nm or more, but is preferably 100 nm or more, and more preferably 500 nm or more in order to obtain sufficient orientation.
However, when the CeO₂ layer is too thick, the crystalline orientation becomes poor, and therefore the thickness is preferably 500 nm to 1000 nm.

As such, when the oxide superconducting layer 15 which will be described below is formed on the cap layer 14 having favorable orientation, the oxide superconducting layer 15 also crystallizes so as to match the orientation of the cap layer 14.
Therefore, the oxide superconducting layer 15 formed on the cap layer 14 has little disarray in the crystalline orientation.
In addition, in each of the crystal grains that compose the oxide superconducting layer 15, the c axis in which it is difficult to apply an electric current in the thickness direction of the substrate 11 is oriented, and a axes or b axes are oriented in the longitudinal direction of the substrate 11.
As a result, the obtained oxide superconducting layer 15 is excellent in terms of the quantum binding properties in crystal grain boundaries, and superconducting characteristics seldom deteriorate in crystal grain boundaries, and therefore it becomes easy to apply an electric current in the longitudinal direction of the substrate 11, and a sufficiently high critical current density can be obtained.

The oxide superconducting layer 15 is composed of a RE123-based oxide superconductor, and the different phase including Tb is dispersed in the oxide superconducting layer 15.
The RE123-based oxide superconductor is a substance which is expressed by a composition of RE₁Ba₂Cu₃O_{y} where RE represents a rare earth element such as Y, La, Nd, Sm, Er, Gd, or the like and 6.5 < y < 7.1 is satisfied). In such a substance, Gd₁Ba₂Cu₃O_{y} or Y₁Ba₂Cu₃O_{y}. is preferable.

The different phase which is distributed to the oxide superconducting layer 15 includes Tb, and this different phase becomes a normal conduction portion and functions as an artificial pin that inhibits movement of the quantized magnetic flux in the oxide superconducting layer 15.
Tb is a rare element in the rare earth elements and the valence of Tb is trivalent or tetravalent.
When the foregoing Tb is introduced into RE₁Ba₂Cu₃O_{y} (RE123-based) oxide superconducting layer 15, the tetravalent Tb forms BaTbO₃, which is an oxidative product of Ba, and grows as a columnar crystal.
Furthermore, the trivalent Tb forms Tb₄O₇ or similar oxidative product and exists so as to be scattered in the oxide superconducting layer 15 as defects (point defect).

Hitherto, tetravalent elements, such as Zr, have been used as a substance known as an artificial pin of a quantized magnetic flux in the RE123-based superconducting layer.
In this case, columnar crystals having the perovskite structure, such as BaZrO₃, are grown in the c-axis direction (the film thickness direction of the superconducting layer; the perpendicular direction to the substrate) by introducing Zr.
However, with the artificial pin of a conventional columnar crystal as described above, crystals in the c-axis direction grew excessively, and the critical current characteristics became favorable in a magnetic field in the c-axis direction; however, when a magnetic field was applied at an angle deviated from the c axis, such as in the vertical direction with respect to the c axis (the horizontal direction of the superconducting layer; the horizontal direction of the substrate), there was a problem in that the critical current characteristics were degraded.
That is, in a method in which the columnar crystals are introduced as an artificial pin, there was a problem in that anisotropy toward a magnetic field was strong.

In the invention, the columnar crystals which are caused by the tetravalent Tb and the point defects which are caused by the trivalent Tb are mixed into the oxide superconducting layer 15 by introducing Tb whose valence is trivalent or tetravalent into the oxide superconducting layer 15.
Because of this, in a case where a magnetic field is applied in the c-axis direction, due to the action of the columnar crystals which are caused by the tetravalent Tb, a pinning effect in which movement of a quantized magnetic flux is inhibited is obtained. In a case where a magnetic field is applied in a direction other than the c-axis direction, due to the action of the point defects which are caused by the trivalent Tb, the effect of movement of the quantized magnetic flux being inhibited is obtained.
That is, in the point defects, anisotropy toward a magnetic field is minor, and it is possible to isotropically inhibit movement of the quantized magnetic flux.
Moreover, since Tb is trivalent or tetravalent, the columnar crystals which are caused by the tetravalent Tb have a tendency to inhibit growth in the c-axis direction as compared with an artificial pin which is columnar crystals having a conventional simple perovskite structure.
As a result, the crystals in the c-axis direction grow into a favorable length such as 10 nm to 100 nm in the columnar crystals of the tetravalent Tb, isotropical pinning effect which is due to the point defects caused by the trivalent Tb is synergistically affected, and the critical current characteristics can be improved in areas at all angles at which a magnetic field is applied.

Regarding the introduction proportion of Tb, it is preferable that Tb elements be introduced into the oxide superconducting layer 15 in a range of 0.1 to 4 mass% with respect to the mother phase of RE₁Ba₂Cu₃O_{y}.
For example, as described hereinbelow, when the oxide superconducting layer 17 is formed by pulse laser deposition (PLD), it is preferable that the target be used which is sintered so that 0.1 to 5 mol% of the powder of Tb₄O₇ is mixed into the powder of RE₁Ba₂Cu₃O_{y} (RE123-based) or the powder including the constituent element of RE₁Ba₂Cu₃O_{y} (RE123-based).
The movement of the quantized magnetic flux is effectively reduced by introducing Tb into the oxide superconducting layer 15 in the range of the foregoing mol% or mass%, a degradation in the critical current in a magnetic field is inhibited, and it is possible to obtain the oxide superconducting conductor 10 exhibiting excellent critical current characteristics.
In contrast, if the introduction proportion of Tb is less than 0.1 mass% or if the mixing amount of the powder of Tb₄O₇ is less than 0.1 mol%, there is a possibility that the pinning effect which is due to introduction of Tb will be less easily obtained.
On the other hand, in the case where the introduction proportion of Tb exceeds 4 mass% or the mixing amount of the powder of Tb₄O₇ exceeds 5 mol%, the percentage of the RE123-based oxide superconductor becomes excessively low in the oxide superconducting layer 15, there is a possibility that the superconducting characteristics of the oxide superconducting conductor 10 are degraded.
The compositional proportion of the oxide superconducting layer 15 can be specified, for example, by specifying the composition thereof based on analytic data using electron beam, by observing the cross-sectional face thereof using a transmission electron microscope (TEM), and by determining the proportion of the different phase thereof.

The thickness of the oxide superconducting layer 15 can be appropriately adjusted according to purpose, but is preferably 0.3 µm to 9 µm, and more preferably 0.5 µm to 5 µm.
In addition, the oxide superconducting layer 15 preferably has a uniform thickness.

The oxide superconducting layer 15 can be laminated by physical vapor deposition, such as sputtering, vacuum deposition, laser deposition, or electron beam deposition; chemical vapor deposition (CVD); dipping-pyrolysis processing (MOD); or the like.
Among the above methods, pulse laser deposition (PLD), a trifluoroacetate-metal organic deposition (TFA-MOD, an organic metal deposition method in which trifluoroacetate is used, dipping-pyrolysis process), or CVD is preferably used from the viewpoint of productivity.

MOD is a method in which a metallic organic salt is coated, and then thermally decomposed.
More specifically, a solution containing an organic compound having metallic components uniformly dissolved therein is coated on a substrate, and then the solution is heated and thermally decomposed, thereby forming a thin film on the substrate.
Since a vacuum process is not required, and a film can be rapidly formed at a low cost, this method is appropriate for manufacturing a tape-shaped elongated oxide superconducting conductor.
During MOD, the introduction proportion of Tb in the formed oxide superconducting layer 15 can be controlled by adjusting the composition of a raw material solution.
During CVD, the introduction proportion of Tb in the formed oxide superconducting layer 15 can be controlled by controlling the type or the flow rate of a raw material gas.
During PLD, the introduction proportion of Tb in the formed oxide superconducting layer 15 can be controlled by adjusting the composition ratio of a target being used.

In the forming of the oxide superconducting layer 15 by the above-described methods, by adjusting the compositional ratio of a raw material such that Tb elements are mixed into the range of 0.1 to 4 mass% with respect to RE₁Ba₂Cu₃O_{y} (RE123-based), it is possible to form a thin film (oxide superconducting layer 15) to which the compositional ratio is reflected.
Specifically, when film formation is carried out by, for example, pulse laser deposition (PLD), it is preferable that the target be used which is sintered so that 0.1 to 5 mol% of the powder of Tb₄O₇ is mixed into the powder of RE₁Ba₂Cu₃O_{y} (RE123-based) or the powder including the constituent element of RE₁Ba₂Cu₃O_{y} (RE123-based).
Due to introducing Tb into the RE123-based oxide superconductor in the range of the foregoing mol% or mass%, the columnar crystals and the point defects are formed as described above, the movement of the quantized magnetic flux is effectively reduced, a degradation in the critical current in a magnetic field is inhibited, and it is possible to obtain the oxide superconducting conductor 10 exhibiting excellent critical current characteristics.
In contrast, if the amount of Tb elements which is mixed into the RE123-based raw material is less than 0.1 mass% or if the mixing amount of the powder of Tb₄O₇ is less than 0.1 mol%, there is a possibility that the pinning effect which is due to introduction of Tb will be less easily obtained.
On the other hand, in the case where the amount of Tb elements which is mixed into the RE123-based raw material exceeds 4 mass% or the mixing amount of the powder of Tb₄O₇ exceeds 5 mol%, the percentage of the RE123-based oxide superconductor becomes excessively low in the oxide superconducting layer 15, there is a possibility that the superconducting characteristics of the oxide superconducting conductor 10 are degraded.

In the invention, among the above methods, the oxide superconducting layer 15 can be particularly preferably formed by PLD which is physical vapor deposition.
Hereinafter, as an embodiment of a method of manufacturing an oxide superconducting conductor of the invention, a manufacturing method by PLD will be described.
FIG. 2 is a schematic perspective view showing an example of a laser deposition apparatus that is used to form an oxide superconducting layer by PLD.

A laser deposition apparatus 20 as shown in FIG. 2 includes a plurality of winding members, such as reels that wind an elongated thin film layered body 25 having the bed layer 12, the intermediate layer 13, and the cap layer 14 sequentially laminated on the substrate 11.
The plurality of winding members are arrayed so that the axial directions of the winding members become substantially in parallel with each other (coaxially arrayed).
More specifically, the laser deposition apparatus 20 has a pair of winding member groups 23 and 24 (a first winding member 23 and a second winding member 24), a delivery reel 21, a winding reel 22, a substrate holder 26, a heating apparatus (not shown), a target 27, and a laser light-emitting apparatus 28.
The pair of winding member groups 23 and 24 are disposed opposite to each other with a gap therebetween.
The delivery reel 21 delivers the thin film layered body 25 which is disposed outside the first winding member group 23.
The winding reel 22 winds the thin film layered body 25 which is disposed outside the second winding member group 24.
The substrate holder 26 supports the thin film layered body 25 that is made to form a plurality of lanes by winding of the winding member groups 23 and 24.
The heating apparatus heats the thin film layered body 25 which is embedded in the substrate holder 26.
The target 27 is disposed opposite to the thin film layered body 25.
The laser light-emitting apparatus 28 irradiates the target 27 with a laser beam L.
Since the pair of winding member groups 23 and 24, the delivery reel 21, and the winding reel 22 are driven in synchronization with each other by a driving apparatus (not shown), the thin film layered body 25 delivered from the delivery reel 21 is circulated through the pair of winding member groups 23 and 24, and wound in the winding reel 22.

The elongated thin film layered body 25 wound in the pair of winding member groups 23 and 24 is circulated through the winding member groups 23 and 24, and disposed so as to compose a plurality of lanes in a deposition particle-deposited area.
Therefore, in the laser deposition apparatus 20 of the embodiment, when the surface of the target 27 is irradiated with the laser beam L, a jet flow (hereinafter denoted as the plume 29) of deposition particles that are sputtered or evaporated from the target 27 is generated, and deposition particles can be deposited toward the surface of the thin film layered body 25 that runs through an area opposite to the target 27.

The target 27 is made of a plate material, such as a sintered article obtained by mixing a compound including Tb into a complex oxide or an oxide superconductor having a composition that is similar or close to that of the oxide superconducting layer 15 to be formed or including a large amount of components that are easily removed while the film is formed in a desired proportion.
Since the oxide superconducting layer 15 of the oxide superconducting conductor 10 of the invention is an RE123-based oxide superconductor including the different phase including Tb, a sintered article or the like in which the compound including Tb is mixed into the powder of RE₁Ba₂Cu₃O_{y} (RE123-based) can be used as the target 27.
It is preferable that, as the target 27, a target be used in which 0.1 to 5 mol% of the powder of Tb₄O₇ is mixed into the powder of RE₁Ba₂Cu₃O_{y} (RE123-based).
Tb elements are mixed into the RE123-based into the oxide superconducting layer 15 by the range of 0.1 to 4 mass% by use of the target 27 in which Tb is mixed at the foregoing percentage, and the different phase of the columnar crystals and the point defects including Tb are introduced thereinto.
Due to the foregoing different phase functioning as an artificial pin of the quantized magnetic flux, it is possible to obtain the oxide superconducting conductor 10 providing excellent critical current characteristics.

As the laser light-emitting apparatus 28 irradiating the target 27 with a laser beam, an apparatus irradiating the target with any laser beam, for example, an excimer laser such as Ar-F (193 nm) and Kr-F (248 nm), a YAG laser, or a CO₂ layer, may be used as long as the apparatus generates the laser beam L that can sputter deposition particles from the target 27.

Next, a method of forming the oxide superconducting layer 15 on the elongated thin film layered body 25 (on the top surface of the cap layer 14 on the substrate 11) using the laser deposition apparatus 20 having the configuration as shown in FIG. 2 will be described.
Firstly, the target 27 is located at a predetermined position, and then the thin film layered body 25 wound in the delivery reel 21 is drawn and sequentially wound in the pair of winding member groups 23 and 24.
After that, the front end side of the thin film layered body 25 is windably mounted on the winding reel 22.
Therefore, the thin film layered body 25 wound in the pair of winding member groups 23 and 24 is circulated through the pair of winding member groups 23 and 24, and arrayed in a plurality of lines at a position opposite to the target 27 so as to be movable.
After that, a vacuuming apparatus (not shown) is driven, and the inside of a treatment chamber (not shown) that is installed so as to cover at least the thin film layered body 25 running between the pair of winding member groups 23 and 24 is depressurized.
At this time, oxygen gas may be introduced to the treatment chamber according to necessity so as to form an oxygen atmosphere in the chamber.

Next, at an appropriate timing before film formation begins by irradiating the target 27 with the laser beam L, at least the thin film layered body 25 running through a film-forming area is heated by making an electric current flow through the heating apparatus (not shown), and then the thin film layered body 25 is maintained at a constant temperature.
The surface temperature of the thin film layered body 25 during film formation can be appropriately adjusted, and can be set to, for example, 780°C to 850°C.

Subsequently, the thin film layered body 25 is delivered from the delivery reel 21, and laser beam L is generated from the laser light-emitting apparatus 28 so as to irradiate the target 27 with the laser beam L.
At this time, it is preferable that the target 27 be irradiated with the laser beam L while scanning the target 27 so as to move the position which is irradiated with the laser beam L on the surface of the target 27.
In addition, it is also preferable to use a target-moving mechanism (not shown) to move the target 27 along the parallel surface of the mechanism.
As described above, a plume 29 is generated sequentially from the entire surface area of the target 27 by moving the position which is irradiated with the laser beam L on the target 27, and particles in the target 27 are sputtered, or particles in the target 27 are evaporated.
Therefore, the oxide superconducting layer 15 that is as uniform as possible can be formed in each of a plurality of lines of the thin film layered body 25 that is arrayed linearly.

Deposition particles sputtered or evaporated from the target 27 generate the plume 29 having a shape whose cross section in the radiation direction enlarges gradually (refer to FIG. 2).
The deposition particles are deposited on the surface of the thin film layered body 25 moving in a plurality of arrays.
Therefore, while the thin film layered body 25 is circulated through the pair of winding member groups 23 and 24, the oxide superconducting layer 15 is repeatedly formed, and the oxide superconducting layer 15 is deposited on the thin film layered body 25 so as to obtain the necessary thickness.
After the formation of the oxide superconducting layer 15, the obtained oxide superconducting conductor 10 is wound in the winding reel 21.
Through the above processes, the oxide superconducting layer 15, in which the columnar crystals including Tb and the different phase which is the point defects are dispersed, can be formed on the thin film layered body 25 (the top surface of the cap layer 14 of the substrate 11).

The stabilizing layer 16 as shown in FIG. 1 is preferably deposited on the oxide superconducting layer 15.
The stabilizing layer 16 deposited on the oxide superconducting layer 15 functions as a bypass for an electric current at which an electric current flowing through the oxide superconducting layer 15 commutates in a case in which a partial area of the oxide superconducting layer 15 is about to be transformed into a normal conduction state.
Due to providing the stabilizing layer 16 in the above manner, the superconducting state of the oxide superconducting layer 15 stabilizes, and the loss of the oxide superconducting layer 15 is prevented.
As a material for the stabilizing layer 16, a material composed of metal having favorable conductivity is preferably employed, and specific examples include materials composed of silver, a silver alloy, copper, or the like.
The structure of the stabilizing layer 16 may be a single layer structure or a laminated structure of two or more layers.
A well-known method is used as a method of laminating the stabilizing layer 16, and a method in which a silver layer is formed through plating or by the sputtering method, and a copper tape or the like is adhered on the silver layer, or the like can be employed.
The thickness of the stabilizing layer 16 can be in a range of 3 µm to 300 µm.

A superconducting wire can be obtained by coating the outer circumferential surface of the oxide superconducting conductor 10 having the above configuration with an insulating layer.
The insulating layer is made of a well-known material, such as a variety of ordinarily used resins or the like.
Specific examples of the resin include a polyimide resin, a polyamide resin, an epoxy resin, an acryl resin, a phenol resin, a melamine resin, a polyester resin, a silicon resin, a silicon resin, an alkyd resin, a vinyl resin, and the like.
The thickness of the coated insulating layer is not particularly limited, and can be appropriately adjusted depending on the portion in the coating target, and the like.
The insulating layer may be formed by a well-known method depending on the material of the insulating material, and, for example, a raw material may be coated and cured.
In addition, in a case in which a sheet-shaped insulating layer can be obtained, the oxide superconducting conductor 10 may be coated with the above insulating layer.

The different phase including Tb, in details, the columnar crystals which are caused by the tetravalent Tb and the point defects which are caused by the trivalent Tb are mixed into the oxide superconducting conductor 10 of the invention by introducing Tb whose valence is trivalent or tetravalent into the oxide superconducting layer 15.
Accordingly, in the case of applying a magnetic field in the c-axis direction, the pinning effect in which movement of a quantized magnetic flux is inhibited is obtained by the columnar crystals. Anisotropy toward a magnetic field is minor in the point defects, and it is possible to isotropically inhibit movement of the quantized magnetic flux.
Moreover, since Tb is trivalent or tetravalent, the columnar crystals which are caused by the tetravalent Tb have a tendency to inhibit growth in the c-axis direction as compared with an artificial pin which is columnar crystals having a conventional simple perovskite structure.
As a result, the crystals in the c-axis direction grow into a favorable length such as 10 nm to 100 nm in the columnar crystals of the tetravalent Tb, isotropical pinning effect which is due to the point defects caused by the trivalent Tb is synergistically affected, and the critical current characteristics can be improved in areas at all angles at which a magnetic field is applied.

Furthermore, according to the method of manufacturing an oxide superconducting conductor of the invention, it is possible to easily manufacture an oxide superconducting conductor exhibiting excellent critical current characteristics by using a raw material in which the constituent element of the oxide superconductor and Tb are mixed at a desired proportion.
Additionally, it is possible to manufacture an oxide superconducting conductor in a simple process with a conventional film formation apparatus by using the target including the constituent element of the oxide superconductor expressed by a composition formula of RE₁Ba₂Cu₃O_{y} and Tb by use of pulse laser deposition (PLD) which is physical vapor deposition.

Thus far, the embodiments of the oxide superconducting conductor and the method of manufacturing the oxide superconducting conductor have been described; however, in the above embodiments, the parts of the oxide superconducting conductor, the method of manufacturing the oxide superconducting wire, and the apparatus in which the oxide superconducting wire is used are examples and can be appropriately modified within the scope of the invention.

### Examples

Hereinafter, the invention will be described in more detail showing examples, but the invention is not limited to the examples.

### (Example 1)

An Al₂O₃ film (the diffusion-preventing layer; film thickness 150 nm) was formed on a 5 mm-wide and 0.1 mm-thick tape-shaped HASTELLOY C276 (trademark of Haynes International, Inc.) substrate by the sputtering method.
Next, an Y₂O₃ film (the bed layer; film thickness 20 nm) was formed on the diffusion-preventing layer by the ion beam sputtering method.
Next, MgO (the intermediate layer; film thickness 10 nm) was formed on the bed layer by ion beam assist deposition (IBAD).
Next, a CeO₂ film (the cap layer; film thickness 500 nm) was formed on the intermediate layer by pulse laser deposition (PLD).
Next, a 1.0 µm-thick RE123-based oxide superconducting layer was formed on the CeO₂ film by pulse laser deposition (PLD) using the laser deposition apparatus 20 as shown in FIG. 2, and, furthermore, a 10 µm-thick Ag (the stabilizing layer) was sputtered on the oxide superconducting layer, thereby manufacturing an oxide superconducting conductor.
Particularly, the oxide superconducting layer was formed using a target obtained by sintering powder containing 2 mol% of Tb₄O₇ mixed into powder of GdBa₂Cu₃O_{y} at a temperature of 800°C, a pressure of 80 Pa, and a laser output of 180 W under an atmosphere of 80% oxygen.

### (Comparative Example 1)

An oxide superconducting conductor was manufactured in the same manner as in Example 1 except that an oxide superconducting layer was formed using a sintered article of GdBa₂Cu₃O_{y} as a target.

### (Comparative Example 2)

An oxide superconducting conductor was manufactured in the same manner as in Example 1 except that an oxide superconducting layer was formed using a sintered article obtained by sintering powder containing 5 mol% of ZrO₂ doped into powder of GdBa₂Cu₃O_{y} as a target.

With regard to the oxide superconducting conductors of Example 1 and Comparative Example 1 and 2, the critical currents Ic0 were measured at the temperature of liquid nitrogen (77K) in the absence of a magnetic field (0T), furthermore, the critical currents Ic were measured under a magnetic field of 0.5 T.

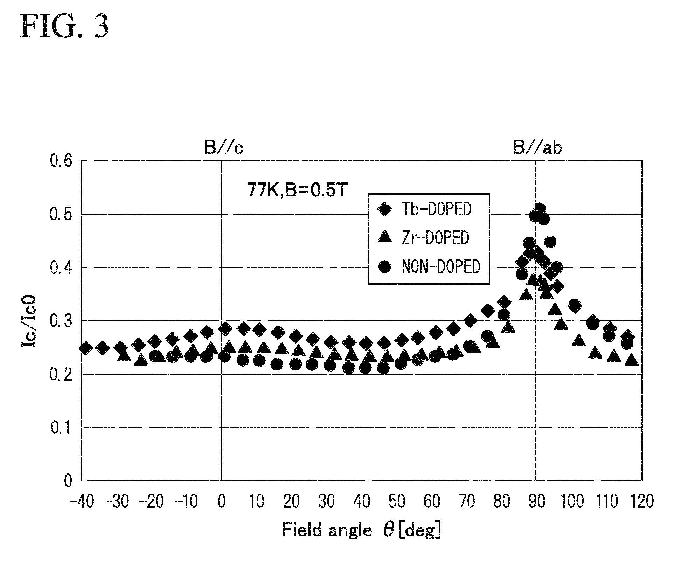

FIG. 3 shows the results obtained by plotting the dependency of the ratios Ic/Ic0 of change in the critical currents on magnetic field application angles with regard to each oxide superconducting conductor.
In FIG. 3, "Tb-DOPED" represents Example 1, "NON-DOPED" represents Comparative Example 1, and "Zr-DOPED" represents Comparative Example 2, respectively.

The results of FIG. 3 show that the oxide superconducting conductor of the Example 1 in which Tb was introduced to an RE123-based oxide superconductor, could suppress degradation of the critical current compared to the oxide superconducting conductors of Comparative Examples 1 and 2 not only in a case in which the magnetic field application angle was in parallel with the c axis (θ = 0°) but also in a case in which a magnetic field was applied at an angle deviated from the c axis (0° < θ < 90°, particularly, near 45°).
Therefore, it is evident that the oxide superconducting conductor of the example 1 suppressed degradation of the critical current in a magnetic field and had favorable critical current characteristics.

### (Example 2: studies of the content of Tb₄O₇)

Sample oxide superconducting conductors 1 to 6 were manufactured in the same manner as in Example 1 except that oxide superconducting layers were formed using a sintered article obtained by sintering powder containing Tb₄O₇ introduced into powder of GdBa₂Cu₃O_{y} at the content as described in Table 1 as a target.
With regard to the obtained oxide superconducting conductors of samples 1 to 6, the critical currents Ic0 were measured at the temperature of liquid nitrogen (77 K) in the absence of a magnetic field (0T).
Furthermore, when the magnetic field was applied at θ = 45° (in the 45° direction with respect to the c axis), the critical currents Ic were measured at the temperature of liquid nitrogen (77K) under a magnetic field of 0.5 T.
With regard to the oxide superconducting conductors of samples 1 to 6, when the magnetic field was applied at θ = 45°, the ratios Ic/Ic0 of change in the critical currents were calculated.
The results are shown in Table 1.

**(Table 1)**

| | CONTENT OF Tb₄O₇ | Ic/Ic0 at θ = 45° |
|---|---|---|
| | (mol%) | |
| SAMPLE 1 | 0 | 0.21 |
| SAMPLE 2 | 0.01 | 0.22 |
| SAMPLE 3 | 0.1 | 0.24 |
| SAMPLE 4 | 2.0 | 0.26 |
| SAMPLE 5 | 5.0 | 0.24 |
| SAMPLE 6 | 6.0 | 0.21 |

It was confirmed from the results as shown in Table 1 that the samples 2 to 5 for which the sintered article obtained by sintering powder containing Tb₄O₇ introduced into powder of GdBa₂Cu₃O_{y} at a content of 0.01 to 5.0 mol% was used as a target could effectively suppress degradation of the critical current as compared with the oxide superconducting conductor of sample 1 into which Tb₄O₇ was not introduced.
Among these results, in samples 3 to 5 using the sintered article obtained by sintering the powder in which 0.1 to 5.0 mol% of Tb₄O₇ was mixed into the powder of GdBa₂Cu₃O_{y}, it was possible to efficiently inhibit the critical currents from being degraded.
Moreover, in sample 6 using the sintered article obtained by sintering the powder in which 6.0 mol% of Tb₄O₇ was mixed into the powder of GdBa₂Cu₃O_{y}, the effect of inhibiting reduction in the critical current was not confirmed.

### Industrial Applicability

According to the oxide superconducting conductor of the invention, the critical current characteristics can be improved in areas at all angles at which a magnetic field is applied.

## Claims

1. An oxide superconducting conductor, comprising:
a substrate; and
an oxide superconducting layer formed on the substrate, the oxide superconducting layer being an oxide superconductor being expressed by a composition formula of RE₁Ba₂Cu₃O_{y} where RE represents a rare earth element and an expression of 6.5 < y < 7.1 is satisfied, the oxide superconducting layer having a different phase including Tb, the different phase being dispersed in the oxide superconducting layer.

2. The oxide superconducting conductor according to claim 1, wherein
the different phase is an oxide including Ba and Tb.

3. The oxide superconducting conductor according to claim 1 or claim 2, wherein
the different phase includes columnar crystals caused by the Tb which is tetravalent and point defects caused by the Tb which is trivalent.

4. The oxide superconducting conductor according to any one of claims 1 to 3, wherein
the Tb is included in the oxide superconducting layer in a range of 0.1 mass% to 4 mass% with respect to the RE₁Ba₂Cu₃O_{y} where RE represents a rare earth element and an expression of 6.5 < y < 7.1 is satisfied.

5. The oxide superconducting conductor according to any one of claims 1 to 4, wherein
an intermediate layer and a cap layer are interposed between the substrate and the oxide superconducting layer in this order, and a stabilizing layer is formed on the oxide superconducting layer.

6. A method of manufacturing an oxide superconducting conductor, comprising:
using a target including a constituent element of an oxide superconductor and Tb, the oxide superconductor being expressed by a composition formula of RE₁Ba₂Cu₃O_{y} where RE represents a rare earth element and an expression of 6.5 < y < 7.1 is satisfied; and
forming an oxide superconducting layer, in which a different phase including Tb is dispersed, on a substrate by physical vapor deposition.

7. The method of manufacturing an oxide superconducting conductor according to claim 6, wherein
as the target, a sintered target is used in which powder of Tb₄O₇ is doped in a range of 0.1 mol% to 5 mol% with respect to powder including the RE₁Ba₂Cu₃O_{y} where RE represents a rare earth element and an expression of 6.5 < y < 7.1 is satisfied.
